# EUROPÄISCHE PATENTSCHRIFT

(11) **EP 2 944 765 B1**
(45) Veröffentlichungstag und Bekanntmachung des Hinweises auf die Patenterteilung: **01.08.2018**
(21) Anmeldenummer: 15166178.2
(22) Anmeldetag: 04.05.2015
(51) Int. Cl.: F01D 5/26, F01D 25/30

(54) **VERFAHREN ZUM AUSLEGEN EINER TURBINE**
METHOD FOR LAYING OUT A TURBINE
PROCÉDÉ DE DIMENSIONNEMENT D'UNE TURBINE

(30) Priorität: 12.05.2014 DE 102014208883
(43) Veröffentlichungstag der Anmeldung: 18.11.2015
(73) Patentinhaber: MTU Aero Engines AG, 80995 München (DE)
(72) Erfinder: Thouault, Nicolas, 81247 München (DE); Broszat, Dominik, 85774 Unterföhring (DE)

(56) Entgegenhaltungen:
- EP-A2- 1 262 636
- DE-A1-102007 042 767
- GB-A- 795 652
- GB-A- 2 475 140
- US-A1- 2007 000 232
- US-A1- 2011 123 342
- Dr Marco Rose: "(Rolls-Royce Deutschland 2012) Tonaler L Tonaler L ä ä rm in Axialen rm in Axialen Turbomaschinen I Turbomaschinen I", , 1. Juni 2012 (2012-06-01), XP055201364, Gefunden im Internet: URL:http://dlr.de/as/Portaldata/5/Resource s/dokumente/abteilungen/abt_ta/Vorl-Ton-Ax ial-2012-06-01.pdf [gefunden am 2015-07-09]

## Beschreibung

Die vorliegende Erfindung betrifft ein Verfahren zum Auslegen einer Turbine, insbesondere einer Niederdruckturbine, einer Gasturbine, insbesondere eines Flugtriebwerks, ein Computerprogrammprodukt zur Durchführung des Verfahrens sowie eine entsprechend ausgelegte Turbine.

Aus dem eigenen europäischen Patent EP 1 738 061 B1 und dem parallelen eigenen US-Patent US 7,806,651 B2 ist ein Verfahren zum Auslegen einer Turbine nach dem Oberbegriff des Anspruchs 1 bzw. eine Turbine nach dem Oberbegriff des Anspruchs 11 bekannt.

Dieses europäische Patent schlägt vor, stromaufwärtige Stufen bis zur Stufe B1/V5 der Turbine derart auszulegen, dass eine Kenngröße vane-to-blade-ratio, die das Verhältnis von der Leitschaufelanzahl zu der Laufschaufelanzahl der Stufe angibt, in lärmkritischen Betriebsbedingungen der Turbine zwischen einer unteren cut-off Grenze für die Mode k=-1 der blade-passing-frequency dieser Stufe und einer oberen cut-off Grenze für die Mode k=-2 der blade-passing-frequency dieser Stufe liegt, um den von der Turbine abgestrahlten Lärmpegel zu reduzieren.

Eine Aufgabe einer Ausführung der vorliegenden Erfindung ist es, eine Turbine einer Gasturbine zu verbessern.

Diese Aufgabe wird durch ein Verfahren mit den Merkmalen des Anspruchs 1 gelöst. Ansprüche 10, 11 stellen ein entsprechendes Computerprogrammprodukt bzw. eine entsprechende Turbine unter Schutz. Vorteilhafte Ausführungsformen der Erfindung sind Gegenstand der Unteransprüche,

Nach einem Aspekt der vorliegenden Erfindung weist eine auszulegende oder ausgelegte Turbine einer Gasturbine eine letzte Stufe bzw. letzte Interaktion mit einem rotierenden, mehrere Laufschaufeln aufweisenden letzten Laufgitter und einem stromabwärts benachbarten, feststehenden und mehrere Leitschaufeln aufweisenden Austrittsleitgitter auf. Stromaufwärts vor dem letzten Laufgitter kann ein feststehendes und mehrere Leitschaufeln aufweisenden Eintrittsleitgitter dieser letzten Stufe angeordnet sein.

Die letzte Stufe ist eine stromabwärtigste bzw. in Durchströmungsrichtung letzte Stufe der Turbine, das letzte Laufgitter entsprechend ein stromabwärtigstes bzw. in Durchströmungsrichtung letztes von vorzugsweise mehreren in Durchströmungsrichtung der Turbine axial hintereinander angeordneten Laufgittern der Turbine, das Austrittsleitgitter, das diesem stromabwärts benachbart angeordnet ist, entsprechend insbesondere ein sogenanntes Turbinenaustritts-Nachleitrad ("Turbine Exit Casing" TEC).

Die Turbine kann insbesondere eine ein- oder mehrstufige Niederdruckturbine sein, die in Durchströmungsrichtung stromabwärts nach einer ein- oder mehrstufigen Hoch- oder Mitteldruckturbine angeordnet sein kann. Die Gasturbine kann insbesondere eine Flugtriebwerk-Gasturbine sein. Sie weist in einer Ausführung eine der Turbine vorgeschaltete Brennkammer und eine oder mehrere dieser Brennkammer vorgeschaltete ein- oder mehrstufige Verdichter auf.

Das Flugtriebwerk kann insbesondere einen Fan aufweisen, der, insbesondere über ein Getriebe, mit der Niederdruckturbine gekoppelt sein kann. In einer Ausführung weist die Turbine einen dem Austrittsleitgitter stromabwärts benachbarten, feststehenden Mischer zum Mischen eines Abgasstroms aus dem Austrittsleitgitter und einem an der Brennkammer vorbeigeführten bzw. zu dem Abgasstrom strömungstechnisch parallelen Bypassluftstrom auf, der durch den Fan beaufschlagt wird.

Die letzte Stufe bzw. letzte akustische Interaktion ist durch eine Kenngröße vane-to-blade-ratio V/B charakterisiert, die das Verhältnis von der Leitschaufel("vane")anzahl V zu der Laufschaufel("blade")anzahl B der letzten Stufe bzw. den Quotienten aus der Anzahl der Leitschaufeln des Austrittsleitgitters dividiert zu der Anzahl der Laufschaufeln des letzten Laufgitters angibt.

Überraschenderweise hat sich herausgestellt, dass sich durch eine Einschnürung des das letzte Laufgitter durchströmenden Abgasstroms nach dem letzten Laufgitter cut-off-Bereiche für die Moden k=-1, k=-2 und k=-3 der blade-passing-frequency der letzten Stufe vergrößern lassen.

Dies ermöglicht es vorteilhaft, die Kenngröße vane-to-blade-ratio für die letzte Stufe dann gezielt und zuverlässig in solche cut-off-Bereiche zu legen und so eine Lärmabstrahlung der Turbine zu reduzieren.

Entsprechend wird bzw. ist nach einem Aspekt der vorliegenden Erfindung die letzte Stufe derart ausgelegt, dass ihre Kenngröße vane-to-blade-ratio in wenigstens einer vorgegebenen Betriebsbedingung der Turbine über einer oberen cut-off Grenze oₖ₌₋₁ für die Mode k=-1 oder zwischen einer unteren cut-off Grenze uₖ₌₋₁ für die Mode k=-1 und einer oberen cut-off Grenze oₖ₌₋₂ für die Mode k=-2 oder zwischen einer unteren cut-off Grenze uₖ₌₋₂ für die Mode k=-2 und einer oberen cut-off Grenze oₖ₌₋₃ für die Mode k=-3 einer blade-passing-frequency der letzten Stufe liegt, wobei die letzte Stufe zusätzlich derart ausgelegt wird bzw. ist, dass ein das letzte Laufgitter durchströmender Abgasstrom in der vorgegebenen Betriebsbedingung vor dem Austrittsleitgitter, insbesondere in einem Bereich zwischen dem letzten Laufgitter und dem Austrittsleitgitter, in dem Austrittsleitgitter bzw. innerhalb des Austrittsleitgitters, und/oder nach dem Austrittsleitgitter, insbesondere in einem Bereich mit einer axialen Länge, die einer axialen Länge des Austrittsleitgitters entspricht, auf einen minimalen Strömungsquerschnitt reduziert wird, der höchstens 80%, insbesondere höchstens 75%, insbesondere höchstens 70%, seines minimalen Strömungsquerschnitts in dem letzten Laufgitter beträgt.

Die vorgegebene Betriebsbedingung kann insbesondere eine lärmkritische Betriebsbedingung sein, wie sie in dem einleitend erläuterten europäischen Patent EP 1 738 061 B1 betrachtet wird, insbesondere ein Startvorgang, ein Landeanflug und/oder ein Rollen auf einem Rollfeld eines Flugzeugs mit der Turbine.

Die blade-passing-frequency bzw. Blattfolgefrequenz bezeichnet in an sich bekannter Weise die Frequenz, mit der die rotierenden Laufschaufeln in der vorgegebenen Betriebsbedingung an einer feststehenden Leitschaufel der letzten Stufe vorbei rotieren.

Ein minimaler Strömungsquerschnitt im Sinne der vorliegenden Erfindung ist insbesondere derjenige kleinste freie Querschnitt eines durch Wandungen begrenzten Strömungskanalabschnitts, der in der vorgegebenen Betriebsbedingung von dem Abgasstrom durchströmt wird bzw. durchströmbar ist. Der minimale Strömungsquerschnitt in dem letzten Laufgitter im Sinne der vorliegenden Erfindung ist insbesondere der kleinste in der vorgegebenen Betriebsbedingung von dem Abgasstrom durchströmte Querschnitt eines axialen Strömungskanalabschnitts zwischen einer stromaufwärtigen Vorder- bzw. Anströmkante und einer stromabwärtigen Hinter- bzw. Abströmkante des letzten Laufgitters, wobei dieser Strömungskanalabschnitt sich radial zwischen einer radial äußeren Gehäusewandung oder einem radial äußeren Außendeckband und einem radial inneren Innendeckband des letzten Laufgitters erstrecken kann. Er kann sich bei konzentrischer Außenwand mit dem Radius R und Innenwand mit dem Radius r sowie der Summe der Querschnittsflächen der Laufschaufeln A_{B} zwischen deren Saug- und Druckseiten zu (R²-r²)π-A_{B} ergeben.

Der Abgasstrom kann stromabwärts des letzten Laufgitters durch eine entsprechende Konturierung des Strömungskanals, insbesondere einen konvergenten Strömungskanalabschnitt, in dem das Austrittsleitgitter angeordnet ist, eingeschnürt werden. Dann kann sich der minimale Strömungsquerschnitt, auf den ein das letzte Laufgitter durchströmender Abgasstrom in der vorgegebenen Betriebsbedingung in dem Austrittsleitgitter reduziert wird, bei konzentrischer Außenwand mit dem Radius R und Innenwand mit dem Radius r sowie der Summe der Querschnittsflächen der Leitschaufeln A_{V} zwischen deren Saug- und Druckseiten zu (R²-r²)π-A_{V} ergeben.

Gleichermaßen kann der Abgasstrom stromabwärts des letzten Laufgitters durch eine entsprechende Trennströmung eingeschnürt werden, die durch Einblasen ausgebildet wird und sich zwischen einer Wandung des Strömungskanals und dem Abgasstrom erstreckt und so einen fluidischen, engeren Strömungskanal für den Abgasstrom bildet. Wenn beispielsweise die Trennströmung eine Schichtdicke von δ aufweist und durch Einblasen eines Einschnürgases von radial außen vor dem Austrittsleitgitter in einem Strömungskanalabschnitt mit konzentrischer Außenwand mit dem Radius R und Innenwand mit dem Radius r ausgebildet wird, so ergibt sich der minimale Strömungsquerschnitt, auf den ein das letzte Laufgitter durchströmender Abgasstrom in der vorgegebenen Betriebsbedingung vor dem Austrittsleitgitter reduziert wird, zu [(R-δ)²-r²]π.

Nach einem Aspekt der vorliegenden Erfindung wird der Abgasstrom somit durch einen konvergenten Strömungskanalabschnitt vor dem Austrittsleitgitter, insbesondere in einem Bereich zwischen dem letzten Laufgitter und dem Austrittsleitgitter, in dem Austrittsleitgitter und/oder nach dem Austrittsleitgitter, insbesondere in einem Bereich mit einer axialen Länge, die einer axialen Länge des Austrittsleitgitters entspricht und somit permanent bzw. in allen Betriebsbedingungen eingeschnürt.

Entsprechend ist bzw. wird die letzte Stufe in einer Ausführung derart ausgelegt, dass der das letzte Laufgitter durchströmende Abgasstrom vor dem Austrittsleitgitter, insbesondere in einem Bereich zwischen dem letzten Laufgitter und dem Austrittsleitgitter, in dem Austrittsleitgitter und/oder nach dem Austrittsleitgitter, insbesondere in einem Bereich mit einer axialen Länge, die einer axialen Länge des Austrittsleitgitters entspricht, permanent bzw. in allen Betriebsbedingungen auf den minimalen Strömungsquerschnitt reduziert wird, der höchstens 80%, insbesondere höchstens 75%, insbesondere höchstens 70%, seines minimalen Strömungsquerschnitts in dem letzten Laufgitter beträgt.

In einer Weiterbildung beträgt hierzu ein minimaler Radius einer radial äußeren Gehäusewandung eines Strömungskanalabschnitts, in dem das Austrittsleitgitter angeordnet ist, höchstens 85%, insbesondere höchstens 82%, insbesondere höchstens 80%, eines minimalen Radius einer radial äußeren Wandung, insbesondere einer radial äußeren Gehäusewandung oder eines radial äußeren Deckbands, eines Strömungskanalabschnitts, in dem das letzte Laufgitter angeordnet ist. Unter einem Radius wird vorliegend insbesondere ein radialer Abstand zu einer Drehachse der Turbine verstanden. Mit anderen Worten kann eine radial äußere Wand des Strömungskanals in Durchströmungsrichtung von dem letzten Laufgitter ausgehend nach radial innen eingezogen sein. Der minimale Radius der radial äußeren Gehäusewandung des Strömungskanalabschnitts, in dem das Austrittsleitgitter angeordnet ist, kann in einer Ausführung zwischen einer stromaufwärtigen Vorder- bzw. Anströmkante und einer stromabwärtigen Hinter- bzw. Abströmkante des Austrittsleitgitters oder auch stromabwärts nach der Hinter- bzw. Abströmkante des Austrittsleitgitters oder stromaufwärts vor der Vorder- bzw. Anströmkante des Austrittsleitgitters angeordnet sein.

Eine solche permanente, konstruktiv bedingte Einschnürung ist vorteilhafterweise einfach und zuverlässig realisierbar.

Nach einem anderen Aspekt der vorliegenden Erfindung wird der Abgasstrom, insbesondere durch Einblasen eines Einschnürgases und/oder einen variablen Strömungskanalquerschnitt, nur in einigen Betriebsbedingungen eingeschnürt, während er in anderen Betriebsbedingungen nicht oder jedenfalls weniger eingeschnürt wird, beispielsweise durch Reduzierung der Einschnürgasströmung oder Vergrößerung des variablen Strömungskanalquerschnitt.

Entsprechend ist bzw. wird die letzte Stufe in einer Ausführung derart ausgelegt, dass der das letzte Laufgitter durchströmende Abgasstrom vor dem Austrittsleitgitter, insbesondere in einem Bereich zwischen dem letzten Laufgitter und dem Austrittsleitgitter, in dem Austrittsleitgitter und/oder nach dem Austrittsleitgitter, insbesondere in einem Bereich mit einer axialen Länge, die einer axialen Länge des Austrittsleitgitters entspricht, in wenigstens einer weiteren Betriebsbedingung, die von der vorgegebenen Betriebsbedingung verschieden ist, auf einen minimalen Strömungsquerschnitt reduziert wird, der mehr als 80% seines minimalen Strömungsquerschnitts in dem letzte Laufgitter beträgt. Insbesondere kann in einer Ausführung die letzte Stufe derart ausgelegt werden bzw. sein, dass der das letzte Laufgitter durchströmende Abgasstrom vor, in und/oder nach dem Austrittsleitgitter in wenigstens einer weiteren Betriebsbedingung, die von der vorgegebenen Betriebsbedingung verschieden ist, wenigstens im Wesentlichen nicht reduziert wird, was vorliegend zur kompakteren Darstellung verallgemeinernd als Reduzierung auf einen Querschnitt bezeichnet wird, der - wenigstens im Wesentlichen - 100% seines minimalen Strömungsquerschnitts in dem letzte Laufgitter beträgt.

Die weitere Betriebsbedingung kann insbesondere ein Reiseflug eines Flugzeugs mit der Turbine sein.

Eine solche temporäre, variable Einschnürung ist vorteilhafterweise an die jeweilige Betriebsbedingung anpassbar. Insbesondere kann ein Wirkungsgrad im Reiseflug verbessert werden.

In einer Weiterbildung ist ein Einblasmittel zum Einblasen eines Einschnürgases zur Ausbildung einer Trennströmung zwischen einer Gehäusewandung eines Strömungskanalabschnitts und dem Abgasstrom vorgesehen, um dessen Strömungsquerschnitt vor, in und/oder nach dem Austrittsleitgitter zu reduzieren.

Das Einblasmittel kann in einer Ausführung ein oder mehrere Eintrittsöffnungen in dem Strömungskanal, eine Einschnürgasquelle, insbesondere eine Ansaugöffnung, Pumpe oder dergleichen, und ein Sperrmittel zum Trennen der Eintrittsöffnungen von der Einschnürgasquelle, insbesondere zum Schließen der Eintrittsöffnungen, aufweisen. Das Einschnürgas kann insbesondere Umgebungs- oder Kühlluft sein. In einer Weiterbildung wird bzw. ist die Umgebungsluft als Einschnürgas gegenüber einer gemittelten Abgasstromtemperatur im Bereich der letzten Stufe um wenigstens 200 K, insbesondere wenigstens 275 K, und/oder höchstens 625 K erwärmt. In einer Ausführung beträgt eine Schichtdicke der Trennströmung in der vorgegebenen Betriebsbedingung wenigstens 10%, insbesondere wenigstens 20%, insbesondere wenigstens 30%, eines minimalen Radius einer radial äußeren Gehäusewandung eines Strömungskanalabschnitts, in dem das Austrittsleitgitter angeordnet ist.

Zusätzlich oder alternativ zu einer Trennströmung kann eine verstellbare Gehäusewandung eines Strömungskanalabschnitts vorgesehen sein, um den Strömungsquerschnitt des Abgasstroms vor, in und/oder nach dem Austrittsleitgitter zu reduzieren. Hierzu kann die Turbine insbesondere eine oder mehrere bewegliche Klappen aufweisen, die nach radial innen verstellbar sind, um den freien Querschnitt des Strömungskanals zu reduzieren.

Kenngrößen vane-to-blade-ratio in einem Bereich zwischen 0,6 und 0,8, insbesondere von wenigstens im Wesentlichen 0,7, sowie in einem Bereich zwischen 0,35 und 0,45, insbesondere von wenigstens im Wesentlichen 0,4, haben sich als besonders vorteilhaft herausgestellt.

In einer Ausführung weist die Turbine eine oder mehrere weitere Stufen stromaufwärts vor der letzte Stufe mit jeweils einem rotierenden, mehrere Laufschaufeln aufweisenden weiteren Laufgitter und einem stromauf- oder -abwärts benachbarten feststehenden, mehrere Leitschaufeln aufweisenden weiteren Leitgitter auf, die jeweils durch eine weitere Kenngröße vane-to-blade-ratio charakterisiert sind, die das Verhältnis von der stromauf- oder -abwärtigen Leitschaufelanzahl zu der Laufschaufelanzahl der weiteren Stufe angibt, und derart ausgelegt sind bzw. werden, dass diese weitere Kenngröße in der vorgegebenen Betriebsbedingung der Turbine über einer oberen cut-off Grenze für die Mode k=-1 oder zwischen einer unteren cut-off Grenze für die Mode k=-1 und einer oberen cut-off Grenze für die Mode k=-2 oder zwischen einer unteren cut-off Grenze für die Mode k=-2 und einer oberen cut-off Grenze für die Mode k=-3 einer blade-passing-frequency der weiteren Stufe liegt, mit welcher ihre Laufschaufeln an einer ihrer stromauf- bzw. -abwärtigen Leitschaufeln vorbeirotieren.

In einer Ausführung sind sowohl die letzte Stufe als auch die ihr stromaufwärts benachbarte weitere Stufe derart ausgelegt, dass ihre Kenngrößen vane-to-blade-ratio jeweils beide über der oberen cut-off Grenze für die Mode k=-1 der blade-passing-frequency der jeweiligen Stufe oder beide zwischen der unteren cut-off Grenze für die Mode k=-1 und der oberen cut-off Grenze für die Mode k=-2 der blade-passing-frequency der jeweiligen Stufe oder beide zwischen der unteren cut-off Grenze für die Mode k=-2 und der oberen cut-off Grenze für die Mode k=-3 der blade-passing-frequency der jeweiligen Stufe liegen.

In einer anderen Ausführung sind die letzte Stufe und die ihr stromaufwärts benachbarte weitere Stufe derart ausgelegt, dass die Kenngrößen vane-to-blade-ratio der letzten Stufe über der oberen cut-off Grenze für die Mode k=-1 der blade-passing-frequency der letzten Stufe und die Kenngrößen vane-to-blade-ratio der weiteren Stufe zwischen der unteren cut-off Grenze für die Mode k=-1 und der oberen cut-off Grenze für die Mode k=-2 oder zwischen der unteren cut-off Grenze für die Mode k=-2 und der oberen cut-off Grenze für die Mode k=-3 der blade-passing-frequency dieser Stufe liegen, oder derart, dass die Kenngrößen vane-to-blade-ratio der letzten Stufe zwischen der unteren cut-off Grenze für die Mode k=-1 und der oberen cut-off Grenze für die Mode k=-2 der blade-passing-frequency der letzten Stufe und die Kenngrößen vane-to-blade-ratio der weiteren Stufe über der oberen cut-off Grenze für die Mode k=-1 oder zwischen der unteren cut-off Grenze für die Mode k=-2 und der oberen cut-off Grenze für die Mode k=-3 der blade-passing-frequency dieser Stufe liegen oder derart, dass die Kenngrößen vane-to-blade-ratio der letzten Stufe zwischen der unteren cut-off Grenze für die Mode k=-2 und der oberen cut-off Grenze für die Mode k=-3 der blade-passing-frequency der letzten Stufe und die Kenngrößen vane-to-blade-ratio der weiteren Stufe über der oberen cut-off Grenze für die Mode k=-1 oder zwischen der unteren cut-off Grenze für die Mode k=-1 und der oberen cut-off Grenze für die Mode k=-2 der blade-passing-frequency dieser Stufe liegen.

Dabei ist zu beachten, dass die Kenngröße vane-to-blade-ratio der letzten Stufe das Verhältnis der Anzahl der Leitschaufeln des stromabwärts benachbarten Austrittsleitgitters zu der Anzahl der Laufschaufeln des letzten Laufgitters angibt, während die weitere Kenngröße vane-to-blade-ratio der weiteren Stufe(n) das Verhältnis der Anzahl der Leitschaufeln des stromaufwärts oder stromabwärts benachbarten Leitgitters zu der Anzahl der Laufschaufeln des Laufgitters dieser weiteren Stufe angeben kann.

Weitere vorteilhafte Weiterbildungen der vorliegenden Erfindung ergeben sich aus den Unteransprüchen und der nachfolgenden Beschreibung bevorzugter Ausführungen. Hierzu zeigt, teilweise schematisiert:
- Fig. 1: einen Teil einer letzten Stufe einer Niederdruckturbine eines Flugtriebwerks nach bisheriger betriebsinterner Praxis;
- Fig. 2: ein Diagramm zur Verdeutlichung einer Auslegung der Niederdruckturbine der Fig. 1 nach bisheriger betriebsinterner Praxis;
- Fig. 3: einen Teil einer letzten Stufe einer Niederdruckturbine eines Flugtriebwerks nach einer Ausführung der vorliegenden Erfindung in Fig. 1 entsprechender Darstellung;
- Fig. 4: ein Diagramm zur Verdeutlichung einer Auslegung der Niederdruckturbine der Fig. 3 nach einer Ausführung der vorliegenden Erfindung in Fig. 2 entsprechender Darstellung;
- Fig. 5: einen Teil einer letzten Stufe einer Niederdruckturbine eines Flugtriebwerks nach einer weiteren Ausführung der vorliegenden Erfindung in Fig. 3 entsprechender Darstellung; und
- Fig. 6: einen Teil einer letzten Stufe einer Niederdruckturbine eines Flugtriebwerks nach einer weiteren Ausführung der vorliegenden Erfindung in Fig. 5 entsprechender Darstellung.

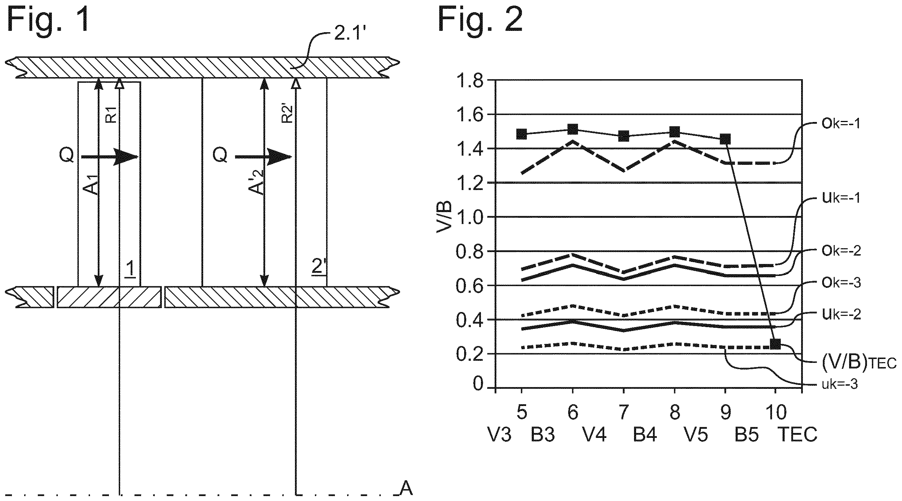

Fig. 2 zeigt in der aus dem europäischen Patent EP 1 738 061 B1 bekannten Darstellungsweise ein Diagramm zur Verdeutlichung einer Auslegung einer Niederdruckturbine nach bisheriger betriebsinterner Praxis, Fig. 1 hierzu einen Teil einer letzten Stufe einer solchen Niederdruckturbine.

Die letzte Stufe weist ein letztes Laufgitter mit mehreren rotierenden Laufschaufeln 1 und ein in Durchströmungsrichtung eines Abgasstroms Q stromabwärts benachbartes, feststehendes Austrittsleitgitter mit mehreren Leitschaufeln 2 auf. Stromaufwärts vor der letzten Stufe sind weitere Stufen mit einem Lauf- und einem Leitgitter angeordnet (nicht dargestellt).

Die Stufen sind jeweils durch eine Kenngröße vane-to-blade-ratio V/B charakterisiert, die das Verhältnis von der Leitschaufelanzahl V zu der Laufschaufelanzahl B der jeweiligen Stufe angibt. Im Diagramm der Fig. 2 sind in der aus dem europäischen Patent EP 1 738 061 B1 an sich bekannten Darstellungsweise als ausgefüllte Quadrate die Kenngröße (V/B)_{TEC} für die letzte Stufe sowie die Kenngrößen V/B für weitere Stufen eingezeichnet. Dabei sind auf der Abszisse das Austrittsleitgitter TEC, das letzte Laufgitter B5 der Turbine sowie weitere, in Strömungsrichtung der letzte Stufe 10 vorgelagerte Leitgitter V5, V4, V3 und weitere Laufgitter B4, B3 aufgetragen.

Ebenfalls in der aus dem europäischen Patent EP 1 738 061 B1 bekannten Darstellungsweise sind in Fig. 2 die jeweilige obere cut-off Grenze oₖ₌₋₁ und die untere cut-off Grenze uₖ₌₋₁ für die Mode k=-1 (strichliert in Fig. 2), die obere cut-off Grenze oₖ₌₋₂ und die untere cut-off Grenze uₖ₌₋₂ für die Mode k=-2 (ausgezogen in Fig. 2) sowie die obere cut-off Grenze oₖ₌₋₃ und die untere cut-off Grenze uₖ₌₋₃ für die Mode k=-3 (punktiert in Fig. 2) der blade-passing-frequency für eine vorgegebene Betriebsbedingung eingezeichnet.

Man erkennt, dass Cut-ON-Bereiche für die Mode k=-2 zwischen den Grenzen oₖ₌₋₂ und uₖ₌₋₂ und für die Mode k=-3 zwischen den Grenzen oₖ₌₋₃ und uₖ₌₋₃ einander überlappen.

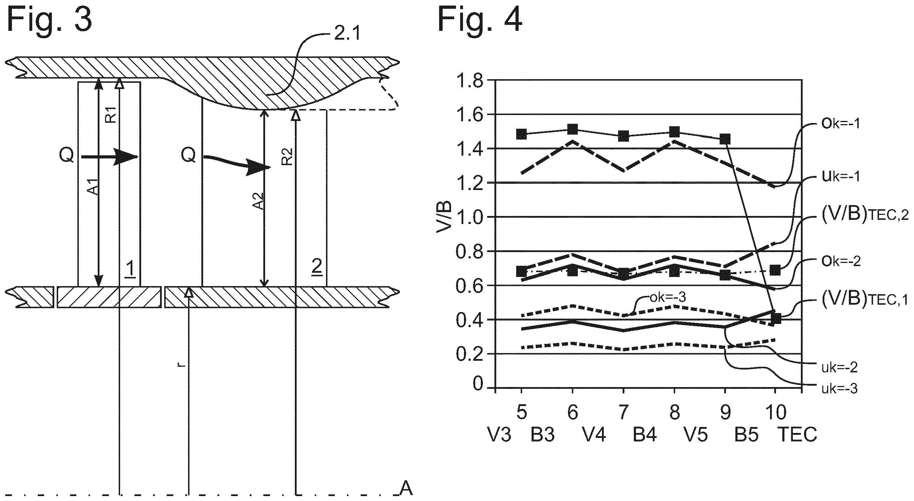

Fig. 4, 3 zeigen nun in Fig. 2, 1 entsprechender Weise ein Diagramm zur Verdeutlichung einer Auslegung einer Niederdruckturbine nach einer Ausführung der vorliegenden Erfindung bzw. einen Teil einer letzten Stufe einer solchen Niederdruckturbine. Einander entsprechende Aspekte sind durch einander entsprechende, gegebenenfalls durch einen Apostroph differenzierte, Bezugszeichen identifiziert, so dass auf vorstehende Beschreibung Bezug genommen und nachfolgend nur auf Unterschiede eingegangen wird.

Die Zusammenschau der Fig. 1, 3 verdeutlicht, dass die letzte Stufe der Niederdruckturbine nach der vorliegenden Erfindung (vgl. Fig. 3) derart ausgelegt wird bzw. ist, dass ein minimaler radialer Abstand zu einer Drehachse A der Turbine, d.h. ein minimaler Radius R2, einer radial äußeren Gehäusewandung 2.1 eines Strömungskanalabschnitts, in dem das Austrittsleitgitter angeordnet ist, höchstens 80% eines minimalen Radius R1 einer radial äußeren Gehäusewandung eines Strömungskanalabschnitts, in dem das letzte Laufgitter angeordnet ist, beträgt, während die letzte Stufe der Niederdruckturbine nach bisheriger betriebsinterner Praxis (vgl. Fig. 1) derart ausgelegt wird bzw. ist, dass ein minimaler Radius R2' einer radial äußeren Gehäusewandung 2.1' eines Strömungskanalabschnitts, in dem das Austrittsleitgitter angeordnet ist, im Wesentlichen dem minimalen Radius R1 einer radial äußeren Gehäusewandung eines Strömungskanalabschnitts, in dem das letzte Laufgitter angeordnet ist, entspricht.

Hierdurch ist bzw. wird die letzte Stufe der Niederdruckturbine nach der vorliegenden Erfindung (vgl. Fig. 3) derart ausgelegt, dass der das letzte Laufgitter durchströmende Abgasstrom Q in dem Austrittsleitgitter permanent bzw. in allen Betriebsbedingungen auf einen minimalen Strömungsquerschnitt A2 reduziert wird, der höchstens 70% seines minimalen Strömungsquerschnitts A1 in dem letzten Laufgitter beträgt. Damit wird der Abgasstrom durch einen konvergenten Strömungskanalabschnitt in dem Austrittsleitgitter und somit permanent bzw. in allen Betriebsbedingungen eingeschnürt.

Überraschenderweise hat sich herausgestellt, dass sich durch eine solche Einschnürung des das letzte Laufgitter durchströmenden Abgasstroms nach dem letzten Laufgitter cut-off-Bereiche für die Moden k=-1, k=-2 und k=-3 der blade-passing-frequency der letzten Stufe vergrößern lassen: wie die Zusammenschau der Fig. 2, 4 verdeutlicht, verengen sich die ungünstigen Cut-ON-Bereich zwischen der oberen cut-off Grenze oₖ₌₋₁ und der unteren cut-off Grenze uₖ₌₋₁ für die Mode k=-1 (strichliert in Fig. 2, 4), zwischen der oberen cut-off Grenze oₖ₌₋₂ und der unteren cut-off Grenze uₖ₌₋₂ für die Mode k=-2 (ausgezogen in Fig. 2, 4) sowie zwischen der oberen cut-off Grenze oₖ₌₋₃ und der unteren cut-off Grenze uₖ₌₋₃ für die Mode k=-3 (punktiert in Fig. 2) der blade-passing-frequency in der vorgegebenen Betriebsbedingung. Entsprechend vergrößern sich die günstigen cut-off-Bereiche außerhalb dieser cut-on-Bereiche.

Dies ermöglicht es vorteilhaft, die Kenngröße vane-to-blade-ratio (V/B)_{TEC} für die letzte Stufe gezielt und zuverlässig in solche cut-off-Bereiche zu legen und so eine Lärmabstrahlung der Turbine zu reduzieren.

In der Fig. 4 ist erkennbar, dass die Kenngröße vane-to-blade-ratio (V/B)_{TEC}, ₁ für die letzte Stufe nach einer Ausführung der vorliegenden Erfindung bei ungefähr 0,4 und damit zwischen der unteren cut-off Grenze uₖ₌₋₂ für die Mode k=-2 und der oberen cut-off Grenze oₖ₌₋₃ für die Mode k=-3 der blade-passing-frequency liegt.

Die der letzten Stufe stromaufwärts benachbarten weiteren Stufe werden bzw. sind hingegen derart ausgelegt, dass ihre Kenngrößen vane-to-blade-ratio V/B über der oberen cut-off Grenze oₖ₌₋₁ für die Mode k=-1 der blade-passing-frequency der jeweiligen Stufe liegen.

Man erkennt in der Zusammenschau der Fig. 2, 4, dass sich durch die erfindungsgemäße Einschnürung des Abgasstroms Q für die letzte Stufe ein cut-off-Bereich zwischen der unteren cut-off Grenze uₖ₌₋₂ für die Mode k=-2 und der oberen cut-off Grenze oₖ₌₋₃ für die Mode k=-3 ergibt (vgl. Fig. 4), der bei der Ausführung nach bisheriger betriebsinterner Praxis (vgl. Fig. 2) nicht vorhanden ist, und dass durch die erfindungsgemäße Auslegung der Kenngröße blade-to-vane-ratio (V/B)_{TEC, 1} für die letzte Stufe in diesem cut-off-Bereich bei günstigen Schaufelzahlen eine Lärmreduzierung der Turbine möglich wird.

In Fig. 4 sind strichpunktiert bzw. als ausgefüllte Quadrate die Kenngröße blade-to-vane-ratio (V/B)_{TEC, 2} für die letzte Stufe sowie die Kenngrößen blade-to-vane-ratio V/B für weitere Stufen für Turbine nach einer weiteren Ausführung der vorliegenden Erfindung eingezeichnet, die bis auf diese Kenngrößen baugleich mit der vorstehend beschriebenen Turbine nach einer Ausführung der vorliegenden Erfindung ist, so dass auf die vorstehende Beschreibung und Fig. 3 Bezug genommen und nachfolgend nur auf Unterschiede eingegangen wird.

Bei dieser weiteren Ausführung liegt die Kenngröße vane-to-blade-ratio (V/B)_{TEC, 2} für die letzte Stufe bei ungefähr 0,7 und damit zwischen der unteren cut-off Grenze uₖ₌₋₁ für die Mode k=-1 und der oberen cut-off Grenze oₖ₌₋₂ für die Mode k=-2 der blade-passing-frequency.

Die der letzten Stufe stromaufwärts benachbarten weiteren Stufen werden bzw. sind ebenfalls derart ausgelegt, dass ihre Kenngrößen vane-to-blade-ratio V/B zwischen der unteren cut-off Grenze uₖ₌₋₁ für die Mode k=-1 und der oberen cut-off Grenze oₖ₌₋₂ für die Mode k=-2 der blade-passing-frequency liegen.

Man erkennt in der Zusammenschau der Fig. 2, 4, dass sich durch die erfindungsgemäße Einschnürung des Abgasstroms Q für die letzte Stufe der cut-off-Bereich zwischen der unteren cut-off Grenze uₖ₌₋₁ für die Mode k=-1 und der oberen cut-off Grenze oₖ₌₋₂ für die Mode k=-2 gegenüber der Ausführung nach bisheriger betriebsinterner Praxis (vgl. Fig. 2) vergrößert, so dass durch die erfindungsgemäße Auslegung der Kenngröße blade-to-vane-ratio (V/B)_{TEC, 2} für die letzte Stufe in diesem cut-off-Bereich zuverlässiger eine Lärmreduzierung der Turbine möglich wird.

In einer Abwandlung weist die Turbine einen dem Austrittsleitgitter stromabwärts benachbarten, feststehenden Mischer zum Mischen eines Abgasstroms aus dem Austrittsleitgitter und einem an der Brennkammer vorbeigeführten Bypassluftstrom auf, der durch einen Fan beaufschlagt wird (nicht dargestellt).

In einer anderen Abwandlung wird der radiale Einzug der Außenwandung des Strömungskanals auch stromabwärts des Austrittsleitgitters beibehalten, wie dies in Fig. 3 strichliert angedeutet ist.

Die für die oben genannten cut-off-Grenzen oₖ₌₋₁,...,uₖ₌₋₃ maßgebliche vorgegebene Betriebsbedingung kann insbesondere eine lärmkritische Betriebsbedingung sein, wie sie in dem einleitend erläuterten europäischen Patent EP 1 738 061 B1 betrachtet wird, insbesondere ein Startvorgang, ein Landeanflug und/oder ein Rollen auf einem Rollfeld eines Flugzeugs mit der Turbine.

Wie in Fig. 3 angedeutet, ist der minimale Strömungsquerschnitt A1 in dem letzten Laufgitter im Sinne der vorliegenden Erfindung der kleinste in der vorgegebenen Betriebsbedingung von dem Abgasstrom durchströmte freie Querschnitt des Strömungskanalabschnitts zwischen einer stromaufwärtigen (links in Fig. 3) Vorder- bzw. Anströmkante und einer stromabwärtigen (rechts in Fig. 3) Hinter- bzw. Abströmkante des letzten Laufgitters Er ergibt sich im Ausführungsbeispiel mit dem Radius r der Innenwand sowie der Summe der Querschnittsflächen der Laufschaufeln A_{B} zu A1=(R1²-r²)π-A_{B}.

In der Ausführung der Fig. 3 wird der Abgasstrom Q stromabwärts des letzten Laufgitters durch eine entsprechende konvergente Konturierung des Strömungskanalabschnitts, in dem das Austrittsleitgitter angeordnet ist, eingeschnürt. Daher ergibt sich der minimale Strömungsquerschnitt A2, auf den der das letzte Laufgitter durchströmender Abgasstrom Q in der vorgegebenen Betriebsbedingung in dem Austrittsleitgitter reduziert wird, mit der Summe der Querschnittsflächen der Leitschaufeln A_{V} zu A2=(R2²-r²)π-A_{V}.

Gleichermaßen kann der Abgasstrom stromabwärts des letzte Laufgitters durch eine entsprechende Trennströmung T mit einer Schichtdicke δ eingeschnürt werden, die durch Einblasen von Einschnürgas ausgebildet wird und sich zwischen einer Wandung 2.1' des Strömungskanals und dem Abgasstrom Q erstreckt und so einen fluidischen, engeren Strömungskanal für den Abgasstrom bildet.

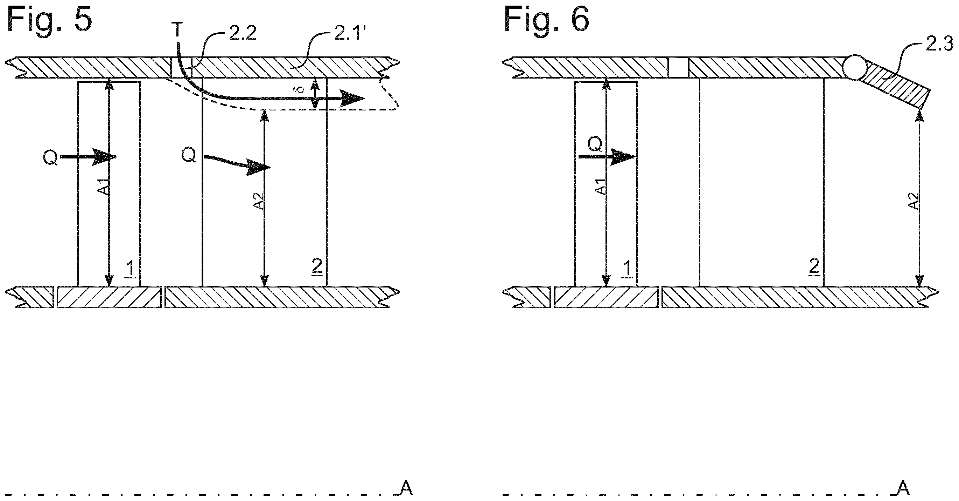

Fig. 5 zeigt hierzu in Fig. 3 entsprechender Weise einen Teil einer letzten Stufe einer solchen Niederdruckturbine nach einer weiteren Ausführung der vorliegenden Erfindung. Einander entsprechende Aspekte sind wiederum durch einander entsprechende Bezugszeichen identifiziert, so dass auf vorstehende Beschreibung Bezug genommen und nachfolgend nur auf Unterschiede eingegangen wird.

In der Ausführung der Fig. 5 weist die Turbine ein Einblasmittel zum Einblasen eines Einschnürgases zur Ausbildung der Trennströmung T zwischen der Gehäusewandung 2.1' eines Strömungskanalabschnitts und dem Abgasstrom Q auf, um dessen Strömungsquerschnitt vor, in und nach dem Austrittsleitgitter zu reduzieren.

Das Einblasmittel weist mehrere Eintrittsöffnungen 2.2 in dem Strömungskanal, eine Einschnürgasquelle und ein Sperrmittel zum wahlweisen Trennen der Eintrittsöffnungen von der Einschnürgasquelle auf (nicht dargestellt). Das Einschnürgas ist Umgebungsluft, die gegenüber einer gemittelten Abgasstromtemperatur im Bereich der letzten Stufe um etwa 300 K erwärmt wird bzw. ist. Hierdurch breitet sich im Bereich der letzten Stufe der Schall in der Strömung des Einschnürgases mit einer anderen Geschwindigkeit aus als der Schall in der Abgasströmung.

Dadurch kann wahlweise je nach Betriebsbedingung, insbesondere in einer vorstehend erläuterten lärmkritischen Betriebsbedingung, der Abgasstrom Q eingeschnürt werden. Somit können wieder die mit Bezug auf Fig. 4 erläuterten cut-off-Bereiche für die Moden k=-1, k=-2 und k=-3 der blade-passing-frequency der letzten Stufe vergrößert und die letzte Stufe derart ausgelegt werden bzw. sein, dass die Kenngröße (V/B)_{TEC, 1} bzw. (V/B)_{TEC, 2} in einer vorgegebenen lärmkritischen Betriebsbedingung zwischen der unteren cut-off Grenze uₖ₌₋₂ für die Mode k=-2 und der oberen cut-off Grenze oₖ₌₋₃ für die Mode k=-3 bzw. zwischen der unteren cut-off Grenze uₖ₌₋₁ für die Mode k=-1 und der oberen cut-off Grenze oₖ₌₋₂ für die Mode k=-2 liegt. Durch Schließen der Eintrittsöffnungen 2.2 kann in einer weiteren Betriebsbedingung, insbesondere einem Reiseflug eines Flugzeugs mit der Turbine, die Einschnürung entfallen.

Eine solche temporäre, variable Einschnürung kann auch durch eine verstellbare Gehäusewandung eines Strömungskanalabschnitts dargestellt werden.

Fig. 6 zeigt hierzu in Fig. 3, 5 entsprechender Weise einen Teil einer letzten Stufe einer solchen Niederdruckturbine nach einer weiteren Ausführung der vorliegenden Erfindung. Einander entsprechende Aspekte sind wiederum durch einander entsprechende Bezugszeichen identifiziert, so dass auf vorstehende Beschreibung Bezug genommen und nachfolgend nur auf Unterschiede eingegangen wird.

In der Ausführung der Fig. 6 weist die Turbine mehrere bewegliche Klappen 2.3 auf, die nach radial innen verstellbar sind, um den freien Querschnitt A2 des Strömungskanals zu reduzieren.

Dadurch kann wahlweise je nach Betriebsbedingung, insbesondere in einer vorstehend erläuterten lärmkritischen Betriebsbedingung, der Abgasstrom Q eingeschnürt werden. Somit können wieder die mit Bezug auf Fig. 4 erläuterten cut-off-Bereiche für die Moden k=-1, k=-2 und k=-3 der blade-passing-frequency der letzten Stufe vergrößert und die letzte Stufe derart ausgelegt werden bzw. sein, dass die Kenngröße (V/B)_{TEC, 1} bzw. (V/B)_{TEC, 2} in der vorgegebenen lärmkritischen Betriebsbedingung zwischen der unteren cut-off Grenze uₖ₌₋₂ für die Mode k=-2 und der oberen cut-off Grenze oₖ₌₋₃ für die Mode k=-3 bzw. zwischen der unteren cut-off Grenze uₖ₌₋₁ für die Mode k=-1 und der oberen cut-off Grenze oₖ₌₋₂ für die Mode k=-2 liegt. Durch Öffnen der Klappen 2.3 kann in einer weiteren Betriebsbedingung, insbesondere einem Reiseflug eines Flugzeugs mit der Turbine, die Einschnürung entfallen.

Obwohl in der vorhergehenden Beschreibung exemplarische Ausführungen erläutert wurden, sei darauf hingewiesen, dass eine Vielzahl von Abwandlungen möglich ist. Außerdem sei darauf hingewiesen, dass es sich bei den exemplarischen Ausführungen lediglich um Beispiele handelt, die den Schutzbereich, die Anwendungen und den Aufbau in keiner Weise einschränken sollen. Vielmehr wird dem Fachmann durch die vorausgehende Beschreibung ein Leitfaden für die Umsetzung von mindestens einer exemplarischen Ausführung gegeben, wobei diverse Änderungen, insbesondere in Hinblick auf die Funktion und Anordnung der beschriebenen Bestandteile, vorgenommen werden können, ohne den Schutzbereich zu verlassen, wie er sich aus den Ansprüchen und diesen äquivalenten Merkmalskombinationen ergibt.

### Bezugszeichenliste

- 1: Laufschaufel
- 2: Leitschaufel
- 2.1; 2.1': Gehäusewandung
- 2.2: Eintrittsöffnung
- 2.3: Klappe
- A1, A2; A2': minimaler Querschnitt
- Q: Abgasstrom
- R1, R2; R2', r: Radius
- T: Trennströmung
- δ: Schichtdicke
- V/B: vane-to-blade-ratio
- oₖ₌₋₁, oₖ₌₋₂, oₖ₌₋₃: obere cut-off Grenze
- uₖ₌₋₁, Uₖ₌₋₂, uₖ₌₋₃: untere cut-off Grenze

## Patentansprüche

1. Verfahren zum Auslegen einer Turbine einer Gasturbine, insbesondere eines Flugtriebwerks, die eine letzte Stufe mit einem rotierenden, mehrere Laufschaufeln (1) aufweisenden letzten Laufgitter und einem stromabwärts benachbarten feststehenden, mehrere Leitschaufeln (2) aufweisenden Austrittsleitgitter aufweist;
wobei die letzte Stufe durch eine Kenngröße vane-to-blade-ratio ((V/B)_{TEC, 1}; (V/B)_{TEC, 2}) charakterisiert ist, die das Verhältnis von der Leitschaufelanzahl zu der Laufschaufelanzahl der letzten Stufe angibt;
**dadurch gekennzeichnet, dass**
ein das letzte Laufgitter durchströmender Abgasstrom (Q) in einer vorgegebenen Betriebsbedingung der Turbine vor dem Austrittsleitgitter, in dem Austrittsleitgitter und/oder nach dem Austrittsleitgitter auf einen minimalen Strömungsquerschnitt (A2) reduziert wird, der höchstens 80% seines minimalen Strömungsquerschnitts (A1) in dem letzten Laufgitter beträgt, so dass sich ein erster cut-off-Bereich zwischen einer unteren cut-off Grenze (uₖ₌₋₁) für die Mode k=-1 und einer oberen cut-off Grenze (oₖ₌₋₂) für die Mode k=-2 einer blade-passing-frequency der letzten Stufe, mit welcher ihre Laufschaufeln an einer ihrer Leitschaufeln vorbeirotieren, vergrößert und ein zweiter cut-off-Bereich zwischen einer unteren cut-off Grenze (uₖ₌₋₂) für die Mode k=-2 und einer oberen cut-off Grenze (oₖ₌₋₃) für die Mode k=-3 der blade-passing-frequency vergrößert oder ergibt, und dass
die letzte Stufe derart ausgelegt wird, dass die Kenngröße vane-to-blade-ratio ((V/B)_{TEC, 1}; (V/B)_{TEC, 2}) in der vorgegebenen Betriebsbedingung in dem ersten cut-off-Bereich oder in dem zweiten cut-off-Bereich liegt.

2. Verfahren nach Anspruch 1, **dadurch gekennzeichnet, dass** die letzte Stufe derart ausgelegt wird, dass der das letzte Laufgitter durchströmende Abgasstrom vor dem Austrittsleitgitter, insbesondere in einem Bereich zwischen dem letzten Laufgitter und dem Austrittsleitgitter, in dem Austrittsleitgitter und/oder nach dem Austrittsleitgitter, insbesondere in einem Bereich mit einer axialen Länge, die einer axialen Länge des Austrittsleitgitters entspricht, permanent auf den minimalen Strömungsquerschnitt reduziert wird, der höchstens 80% seines minimalen Strömungsquerschnitts in dem letzten Laufgitter beträgt.

3. Verfahren nach Anspruch 2, **dadurch gekennzeichnet, dass** ein minimaler Radius (R2) einer radial äußeren Gehäusewandung (2.1) eines Strömungskanalabschnitts, in dem das Austrittsleitgitter angeordnet ist, höchstens 85% eines minimalen Radius (R1) einer radial äußeren Wandung (2.1) eines Strömungskanalabschnitts beträgt, in dem das letzte Laufgitter angeordnet ist.

4. Verfahren nach Anspruch 1, **dadurch gekennzeichnet, dass** die letzte Stufe derart ausgelegt wird, dass der das letzte Laufgitter durchströmende Abgasstrom vor dem Austrittsleitgitter, insbesondere in einem Bereich zwischen dem letzten Laufgitter und dem Austrittsleitgitter, in dem Austrittsleitgitter und/oder nach dem Austrittsleitgitter, insbesondere in einem Bereich mit einer axialen Länge, die einer axialen Länge des Austrittsleitgitters entspricht, in einer weiteren Betriebsbedingung, die von der vorgegebenen Betriebsbedingung verschieden ist, auf einen minimalen Strömungsquerschnitt (A2), der mehr als 80% seines minimalen Strömungsquerschnitts (A1) in dem letzten Laufgitter beträgt, reduziert wird, insbesondere wenigstens im Wesentlichen nicht reduziert wird.

5. Verfahren nach Anspruch 4, **gekennzeichnet durch** ein Einblasmittel (2.2) zum Einblasen eines Einschnürgases, insbesondere von, insbesondere erwärmter, Umgebungsluft, zur Ausbildung einer Trennströmung (T) zwischen einer Gehäusewandung (2.1') eines Strömungskanalabschnitts und dem Abgasstrom (Q), um dessen Strömungsquerschnitt (A2) vor dem Austrittsleitgitter, insbesondere in einem Bereich zwischen dem letzten Laufgitter und dem Austrittsleitgitter, in dem Austrittsleitgitter und/oder nach dem Austrittsleitgitter, insbesondere in einem Bereich mit einer axialen Länge, die einer axialen Länge des Austrittsleitgitters entspricht, zu reduzieren.

6. Verfahren nach Anspruch 4 oder 5, **gekennzeichnet durch** eine verstellbare Gehäusewandung (2.3) eines Strömungskanalabschnitts, um den Strömungsquerschnitt (A2) des Abgasstroms vor dem Austrittsleitgitter, insbesondere in einem Bereich zwischen dem letzten Laufgitter und dem Austrittsleitgitter, in dem Austrittsleitgitter und/oder nach dem Austrittsleitgitter, insbesondere in einem Bereich mit einer axialen Länge, die einer axialen Länge des Austrittsleitgitters entspricht, zu reduzieren.

7. Verfahren nach einem der vorhergehenden Ansprüche, **dadurch gekennzeichnet, dass** die letzte Stufe derart ausgelegt wird, dass die Kenngröße vane-to-blade-ratio wenigstens 0,6 und/oder höchstens 0,8 beträgt.

8. Verfahren nach einem der vorhergehenden Ansprüche 1 bis 6, **dadurch gekennzeichnet, dass** die letzte Stufe derart ausgelegt wird, dass die Kenngröße vane-to-blade-ratio wenigstens 0,35 und/oder höchstens 0,45 beträgt.

9. Verfahren nach einem der vorhergehenden Ansprüche, **dadurch gekennzeichnet, dass** die Turbine wenigstens eine weitere Stufe stromaufwärts vor der letzten Stufe mit einem rotierenden, mehrere Laufschaufeln aufweisenden weiteren Laufgitter und einem diesem stromauf- oder -abwärts benachbarten feststehenden, mehrere Leitschaufeln aufweisenden weiteren Leitgitter aufweist, wobei die weitere Stufe durch eine weitere Kenngröße (V/B) charakterisiert ist, die das Verhältnis von der Leitschaufelanzahl (V) zu der Laufschaufelanzahl (B) der weiteren Stufe angibt, und wobei die weitere Stufe derart ausgelegt wird, dass diese weitere Kenngröße in der vorgegebenen Betriebsbedingung der Turbine über einer oberen cut-off Grenze für die Mode k=-1 oder zwischen einer unteren cut-off Grenze für die Mode k=-1 und einer oberen cut-off Grenze für die Mode k=-2 oder zwischen einer unteren cut-off Grenze für die Mode k=-2 und einer oberen cut-off Grenze für die Mode k=-3 einer blade-passing-frequency der weiteren Stufe liegt, mit welcher ihre Laufschaufeln an einer ihrer Leitschaufeln vorbeirotieren.

10. Computerprogrammprodukt mit einem Programmcode, der auf einem von einem Computer lesbaren Medium gespeichert ist, zur Durchführung des Verfahrens nach einem der vorhergehenden Ansprüche.

11. Turbine einer Gasturbine, insbesondere eines Flugtriebwerks, die eine letzte Stufe mit einem rotierenden, mehrere Laufschaufeln (1) aufweisenden letzten Laufgitter und einem stromabwärts benachbarten feststehenden, mehrere Leitschaufeln (2) aufweisenden Austrittsleitgitter aufweist;
wobei die letzte Stufe durch eine Kenngröße vane-to-blade-ratio ((V/B)_{TEC, 1}; (V/B)_{TEC, 2}) charakterisiert ist, die das Verhältnis von der Leitschaufelanzahl zu der Laufschaufelanzahl der letzten Stufe angibt;
**dadurch gekennzeichnet, dass** die Turbine nach einem Verfahren nach einem der vorhergehenden Ansprüche ausgelegt ist.

## Claims

1. Method for designing a turbine of a gas turbine, in particular of an aircraft engine, that comprises a final stage comprising a rotating final moving grate that has a plurality of rotor blades (1), and a fixed outlet guide grate that is adjacent downstream thereof and has a plurality of guide vanes (2);
the final stage being **characterized by** a vane-to-blade ratio ((V/B)_{TEC, 1}; (V/B)_{TEC, 2}) characteristic variable that specifies the ratio of the number of guide vanes to the number of rotor blades of the final stage;
**characterized in that**
an exhaust gas flow (Q) flowing through the final moving grate is reduced, under specified operating conditions of the turbine and upstream of the outlet guide grate, in the outlet guide grate and/or downstream of the outlet guide grate, to a minimum flow cross section (A2) that is at most 80% of the minimum flow cross section (A1) of said gas flow in the final moving grate, such that a first cut-off region between a lower cut-off boundary (uₖ₌₋₁) for the mode k=-1 and an upper cut-off boundary (oₖ₌₋₂) for the mode k=-2 of a blade-passing frequency of the final stage, at which the rotor blades thereof rotate past one of the guide vanes thereof, increases, and a second cut-off region between a lower cut-off boundary (uₖ₌₋₂) for the mode k=-2 and an upper cut-off boundary (oₖ₌₋₃) for the mode k=-3 of the blade-passing frequency increases or results, and **in that**
the final stage is designed such that, under the specified operating conditions, the vane-to-blade ratio ((V/B)_{TEC, 1}; (V/B)_{TEC, 2}) characteristic variable is in the first-cut-off region or in the second cut-off region.

2. Method according to claim 1, **characterized in that** the final stage is designed such that the outlet gas flow flowing through the final moving grate is permanently reduced, upstream of the outlet guide grate, in particular in a region between the final moving grate and the outlet guide grate, in the outlet guide grate and/or downstream of the outlet guide grate, in particular in a region having an axial length that corresponds to an axial length of the outlet guide grate, to the minimum flow cross section that is at most 80% of the minimum flow cross section of said gas flow in the final moving grate.

3. Method according to claim 2, **characterized in that** a minimum radius (R2) of a radially outer housing wall (2.1) of a flow channel portion in which the outlet guide grate is arranged is at most 85% of a minimum radius (R1) of a radially outer wall (2.1) of a flow channel portion in which the final moving grate is arranged.

4. Method according to claim 1, **characterized in that** the final stage is designed such that, under further operating conditions that are different from the specified operating conditions, the outlet gas flow flowing through the final moving grate is reduced, in particular at least substantially not reduced, upstream of the outlet guide grate, in particular in a region between the final moving grate and the outlet guide grate, in the outlet guide grate and/or downstream of the outlet guide grate, in particular in a region having an axial length that corresponds to an axial length of the outlet guide grate, to a minimum flow cross section (A2) that is more than 80% of the minimum flow cross section (A1) of said gas flow in the final moving grate.

5. Method according to claim 4, **characterized by** a blowing means (2.2) for blowing in a constriction gas, in particular ambient air, in particular heated, in order to form a separating flow (T) between a housing wall (2.1') of a flow channel portion and the exhaust gas flow (Q) so as to reduce the flow cross section (A2) of said exhaust gas flow, upstream of the outlet guide grate, in particular in a region between the final moving grate and the outlet guide grate, in the outlet guide grate and/or downstream of the outlet guide grate, in particular in a region having an axial length that corresponds to an axial length of the outlet guide grate.

6. Method according to either claim 4 or claim 5, **characterized by** an adjustable housing wall (2.3) of a flow channel portion in order to reduce the flow cross section (A2) of the exhaust gas flow, upstream of the outlet guide grate, in particular in a region between the final moving grate and the outlet guide grate, in the outlet guide grate and/or downstream of the outlet guide grate, in particular in a region having an axial length that corresponds to an axial length of the outlet guide grate.

7. Method according to any of the preceding claims, **characterized in that** the final stage is designed such that the vane-to-blade ratio characteristic variable is at least 0.6 and/or at most 0.8.

8. Method according to any of the preceding claims 1 to 6, **characterized in that** the final stage is designed such that the vane-to-blade ratio characteristic variable is at least 0.35 and/or at most 0.45.

9. Method according to any of the preceding claims, **characterized in that** the turbine comprises at least one further stage that is upstream of the final stage and comprises a rotating further moving grate that has a plurality of rotor blades, and a fixed further guide grate that is adjacent upstream or downstream thereof and has a plurality of guide vanes, the further stage being **characterized by** a further characteristic variable (V/B) that specifies the ratio of the number of guide vanes (V) to the number of rotor blades (B) of the further stage, and the further stage being designed such that, under the specified operating conditions of the turbine, said further characteristic variable is above an upper cut-off boundary for the mode k=-1 or between a lower cut-off boundary for the mode k=-1 and an upper cut-off boundary for the mode k=-2, or between a lower cut-off boundary for the mode k=-2 and an upper cut-off boundary for the mode k=-3 of a blade-passing frequency of the further stage, at which the rotor blades thereof rotate past one of the guide vanes thereof.

10. Computer program product comprising a program code, stored on a computer-readable medium, for carrying out the method according to any of the preceding claims.

11. Turbine of a gas turbine, in particular of an aircraft engine, comprising a final stage comprising a rotating final moving grate that has a plurality of rotor blades (1), and a fixed outlet guide grate that is adjacent downstream thereof and has a plurality of guide vanes (2);
the final stage being **characterized by** a vane-to-blade ratio ((V/B)_{TEC, 1}; (V/B)_{TEC, 2}) characteristic variable that specifies the ratio of the number of guide vanes to the number of rotor blades of the final stage;
**characterized in that** the turbine is designed in accordance with a method according to any of the preceding claims.

## Revendications

1. Procédé de dimensionnement d'une turbine d'une turbine à gaz, en particulier d'un réacteur d'aéronef, qui possède un dernier étage comportant une dernière grille mobile rotative dotée de plusieurs aubes mobiles (1) et une grille de guidage de sortie fixe adjacente en aval dotée de plusieurs aubes directrices (2) ;
le dernier étage étant **caractérisé par** un paramètre vane-to-blade-ratio ((V/B)_{TEC, 1}; (V/B)_{TEC, 2}), qui indique le rapport entre le nombre d'aubes directrices et le nombre d'aubes mobiles du dernier étage ;
**caractérisé en ce que**
un courant de gaz d'échappement (Q) traversant la dernière grille mobile, dans une condition de fonctionnement prédéfinie de la turbine avant, dans et/ou après la grille de guidage de sortie, est réduit sur une section transversale d'écoulement (A2) minimale, qui vaut au maximum 80 % de sa section transversale d'écoulement (A1) dans la dernière grille mobile, de sorte que s'amplifie une première plage de cut-off entre une limite inférieure de cut-off (uₖ₌₋₁) pour le mode k=-1 et une limite supérieure de cut-off (oₖ₌₋₂) pour le mode k=-2 d'une blade-passing-frequency du dernier étage, sur la base de laquelle ses aubes mobiles tournent devant une de ses aubes directrices, et que s'amplifie ou produit une seconde plage de cut-off entre une limite inférieure de cut-off (uₖ₌₋₂) pour le mode k=-2 et une limite supérieure de cut-off (oₖ₌₋₃) pour le mode k=-3 de la blade-passing-frequency, et que
le dernier étage est dimensionné de telle sorte que le paramètre vane-to-blade-ratio ((V/B)_{TEC, 1} ; (V/B)_{TEC, 2}) dans la condition de fonctionnement prédéfinie se situe dans la première plage de cut-off ou dans la seconde plage de cut-off.

2. Procédé selon la revendication 1, **caractérisé en ce que** le dernier étage est dimensionné de telle sorte que le courant de gaz d'échappement traversant la dernière grille mobile est réduit de manière permanente sur la section transversale minimale d'écoulement avant la grille de guidage de sortie, en particulier dans la zone entre la dernière grille mobile et la grille de guidage de sortie, dans la grille de guidage de sortie et/ou après la grille de guidage de sortie, en particulier dans une zone dotée d'une longueur axiale correspondant à une longueur axiale de la grille de guidage de sortie, qui vaut au maximum 80 % de sa section transversale minimale d'écoulement dans la dernière grille mobile.

3. Procédé selon la revendication 2, **caractérisé en ce qu'**un rayon minimal (R2) d'une paroi de boîtier (2.1) radialement extérieure d'une section de canal d'écoulement, dans laquelle la grille de guidage de sortie est agencée, vaut au maximum 85 % d'un rayon minimal (R1) d'une paroi (2.1) radialement extérieure d'une section de canal d'écoulement dans laquelle la dernière grille mobile est disposée.

4. Procédé selon la revendication 1, **caractérisé en ce que** le dernier étage est dimensionné de telle sorte que le gaz d'échappement traversant la dernière grille mobile est réduit, en particulier n'est au moins pas sensiblement réduit, avant la grille de guidage de sortie, en particulier dans la zone entre la dernière grille mobile et la grille de guidage de sortie, dans la grille de guidage de sortie et/ou après la grille de guidage de sortie, en particulier dans une zone ayant une longueur axiale correspondant à une longueur axiale de la grille de guidage de sortie, dans une autre condition de fonctionnement différente de la condition de fonctionnement prédéfinie, sur une section transversale minimale d'écoulement (A2) valant plus de 80 % de sa section transversale minimale d'écoulement (A1) dans la dernière grille mobile.

5. Procédé selon la revendication 4, **caractérisé par** un moyen d'injection (2.2) destiné à injecter un gaz de bridage, en particulier de l'air ambiant, en particulier réchauffé, afin de former un courant séparateur (T) entre une paroi de boîtier (2.1') d'une section de canal d'écoulement et le gaz d'échappement (Q), afin de réduire sa section transversale d'écoulement (A2) avant la grille de guidage de sortie, en particulier dans une zone entre la dernière grille mobile et la grille de guidage de sortie, dans la grille de guidage de sortie et/ou après la grille de guidage de sortie, en particulier dans une zone ayant une longueur axiale correspondant à une longueur axiale de la grille de guidage de sortie.

6. Procédé selon la revendication 4 ou 5, **caractérisé par** une paroi de boîtier (2.3) réglable d'une section de canal d'écoulement, afin de réduire la section transversale d'écoulement (A2) du gaz d'échappement avant la grille de guidage de sortie, en particulier dans une zone entre la dernière grille mobile et la grille de guidage de sortie, dans la grille de guidage de sortie et/ou après la grille de guidage de sortie, en particulier dans une zone ayant une longueur axiale correspondant à une longueur axiale de la grille de guidage de sortie.

7. Procédé selon l'une des revendications précédentes, **caractérisé en ce que** le dernier étage est dimensionné de telle sorte à ce que le paramètre vane-to-blade-ratio vaut au moins 0,6 et/ou au maximum 0,8.

8. Procédé selon l'une des revendications 1 à 6, **caractérisé en ce que** le dernier étage est dimensionné de telle sorte que le paramètre vane-to-blade-ratio vaut au moins 0,35 et/ou au maximum 0,45.

9. Procédé selon l'une des revendications précédentes, **caractérisé en ce que** la turbine possède au moins un autre étage en amont avant le dernier étage comportant une autre grille mobile rotative dotée de plusieurs aubes mobiles et une autre grille de guidage fixe adjacente en amont ou en aval à celle-ci dotée de plusieurs aubes directrices, l'autre étage étant **caractérisé par** un autre paramètre (V/B) qui indique le rapport entre le nombre d'aubes directrices (V) et le nombre d'aubes mobiles (B) de l'autre étage, et l'autre étage étant dimensionné de manière à ce que cet autre paramètre se trouve, dans la condition de fonctionnement prédéfinie de la turbine, au-dessus d'une limite supérieure de cut-off pour le mode k=-1 ou entre une limite inférieure de cut-off pour le mode k=-1 et une limite supérieure de cut-off pour le mode k=-2 ou entre une limite inférieure de cut-off pour le mode k=-2 et une limite supérieure de cut-off pour le mode k=-3 d'une blade-passing-frequency de l'autre étage, sur la base de laquelle ses aubes mobiles tournent devant une de ses aubes directrices.

10. Produit de programme informatique comportant un code de programme qui est sauvegardé sur un support lisible par ordinateur, destiné à exécuter le procédé selon l'une des revendications précédentes.

11. Turbine d'une turbine à gaz, en particulier d'un réacteur d'aéronef, qui possède un dernier étage comportant une dernière grille mobile rotative dotée de plusieurs aubes mobiles (1) et une grille de guidage de sortie fixe adjacente en aval dotée de plusieurs aubes directrices (2) ;
le dernier étage étant **caractérisé par** un paramètre vane-to-blade-ratio ((V/B)_{TEC, 1} ; (V/B)_{TEC, 2}) qui indique le rapport du nombre d'aubes directrices sur le nombre d'aubes mobiles du dernier étage ;
**caractérisé en ce que** la turbine est dimensionnée selon un procédé selon l'une des revendications précédentes.
